(19) Europäisches Patentamt
European Patent Office
Office européen des brevets

(11) **EP 2 945 160 B1**

(12) **FASCICULE DE BREVET EUROPEEN**

(45) Date de publication et mention
de la délivrance du brevet:
**15.03.2017 Bulletin 2017/11**

(51) Int Cl.:
*G11C 11/16* *(2006.01)*   *G11C 11/44* *(2006.01)*
*H01L 39/22* *(2006.01)*

(21) Numéro de dépôt: **15167857.0**

(22) Date de dépôt: **15.05.2015**

(54) **COMPOSANT ÉLECTRONIQUE À JONCTION JOSEPHSON**

ELEKTRONISCHE KOMPONENTE MIT JOSEPHSON-KONTAKT

JOSEPHSON JUNCTION ELECTRONIC COMPONENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.05.2014 FR 1401094**

(43) Date de publication de la demande:
**18.11.2015 Bulletin 2015/47**

(73) Titulaires:
• **THALES**
**92400 Courbevoie (FR)**
• **Centre National de la Recherche Scientifique (C.N.R.S.)**
**75016 Paris (FR)**

(72) Inventeurs:
• **Villegas, Javier**
**92140 CLAMART (FR)**
• **Crete, Denis**
**91767 PALAISEAU CEDEX (FR)**
• **Marcilhac, Bruno**
**91767 PALAISEAU CEDEX (FR)**

(74) Mandataire: **Lavoix**
**2, place d'Estienne d'Orves**
**75441 Paris Cedex 09 (FR)**

(56) Documents cités:
**EP-A1- 0 482 198      RU-C1- 2 373 610**
**US-A1- 2011 267 878**

• **NIEDZIELSKI ET AL: "Use of Pd-Fe and Ni-Fe-Nb as Soft Magnetic Layers in Ferromagnetic Josephson Junctions for Nonvolatile Cryo", IEEE TRANSACTIONS ON APPLIED SUPERCONDUCTIVITY, vol. 24, no. 4, 1 août 2014 (2014-08-01), pages 1-7, XP011544947, ISSN: 1051-8223, DOI: 10.1109/TASC.2014.2311442 [extrait le 2014-04-07]**
• **ALIDOUST ET AL: "Spin-triplet supercurrent through inhomogeneous ferromagnetic trilayers", PHYSICAL REVIEW B, vol. 82, no. 22, 1 décembre 2010 (2010-12-01), page 224504, XP055173535, ISSN: 1098-0121, DOI: 10.1103/PhysRevB.82.224504**
• **VEDYAYEV ET AL: "Spin-valve magnetic sandwich in a Josephson junction", EUROPHYSICS LETTERS, vol. 71, no. 4, 1 août 2005 (2005-08-01), pages 679-685, XP055173253, ISSN: 0295-5075, DOI: 10.1209/epl/i2005-10118-y**
• **GUSAKOVA ET AL: "Energy variation of DOS in spin-valve structure with superconducting electrodes", JOURNAL OF MAGNETISM AND MAGNETIC MATERIALS, vol. 300, no. 1, 1 mai 2006 (2006-05-01), pages e247-e250, XP024984222, ISSN: 0304-8853, DOI: 10.1016/J.JMMM.2005.10.091 [extrait le 2006-05-01]**

EP 2 945 160 B1

**Description**

La présente invention est relative aux composants électroniques comportant une jonction Josephson. Plus particulièrement, elle est relative aux circuits de logique rapide, dits RSFQ (selon l'acronyme anglais « Rapid Single Flux Quantum »), fondés sur de tels composants, dans le but d'atteindre des fréquences de fonctionnement de l'ordre de quelques centaines de GHz.

De manière connue, une jonction Josephson comporte des première et seconde couches en un matériau supraconducteur, séparées l'une de l'autre par une couche intermédiaire en un matériau non-supraconducteur.

Dans un milieu supraconducteur, les porteurs de charge sont constitués par l'association de deux électrons, au sein d'une paire de Cooper. Dans les supraconducteurs dits « conventionnels », les électrons associés présentent des spins opposés, la paire de Cooper possédant alors un spin nul. La statistique suivie par un gaz de paires de Cooper est une statistique de Bose-Einstein, selon laquelle plusieurs paires de Cooper peuvent occuper simultanément le même état quantique. En particulier, à une température inférieure à une température critique, toutes les paires de Cooper se condensent dans le même état quantique fondamental.

De ce fait, le gaz de porteurs de charge est décrit macroscopiquement par une fonction d'onde quantique. Celle-ci présente une phase $\theta$.

Dans une jonction Josephson, bien que la continuité du matériau supraconducteur soit interrompue par la présence du matériau non-supraconducteur de la couche intermédiaire, il existe un couplage entre les fonctions d'onde des porteurs de charge dans les première et seconde couches supraconductrices.

En effet, selon l'effet Josephson, la fonction d'onde des porteurs de charge de la première couche supraconductrice s'étend à travers la couche intermédiaire, jusque dans la seconde couche supraconductrice où elle interfère avec la fonction d'onde des porteurs de charge de la seconde couche supraconductrice.

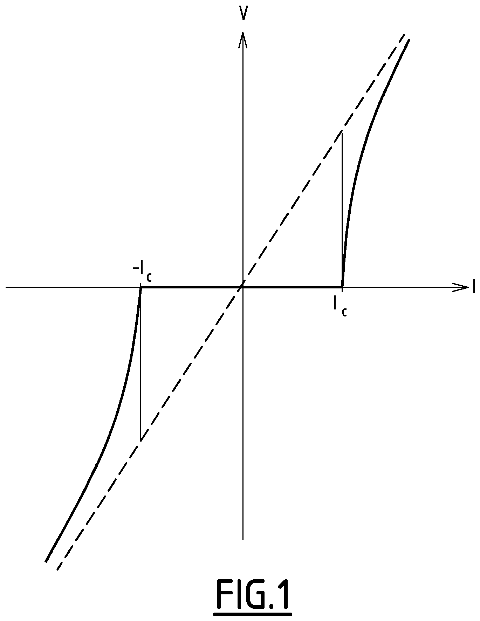

La caractéristique courant - tension d'une jonction Josephson, dont le matériau intermédiaire est un métal, est représentée de manière schématique à la figure 1.

On montre que le courant $I$ et la tension V prennent la forme paramétrique suivante :

$$I = \frac{\Phi_0}{2\pi R}\frac{d\varphi}{dt} + I_c \sin\varphi \qquad (1)$$

$$V = \frac{\Phi_0}{2\pi}\frac{d\varphi}{dt} \qquad (2)$$

Où

- Le paramètre $\varphi = \theta_1 - \theta_2$ correspond à la différence entre les phases des fonctions d'ondes des porteurs de charge dans les première et seconde couches supraconductrices, respectivement ;
- $\Phi_0$ est une constante caractéristique de l'effet Josephson et s'exprime en fonction de la constante de Planck $\underline{h}$ et de la charge de l'électron $\underline{e}$ selon : $\Phi_0 = \frac{h}{2e}$ ;
- R est dénommée résistance normale et correspondant à la pente des branches asymptotiques de la caractéristique courant - tension ;
- t représente le temps ; et,
- $I_c$ est un courant critique, caractéristique de la jonction Josephson.

Il existe une solution pour laquelle la différence de phase $\varphi$ est constante dans le temps. La tension $V$ est nulle, mais un courant continu peut être mis en circulation à travers la jonction Josephson. Ce courant continu est inférieur à $I_c$, à cause du terme en $\sin\varphi$ dans la relation (1).

Il existe également une solution pour laquelle la tension $V$ est constante et non nulle. La différence de phase est alors une fonction monotone croissante en fonction du temps. Un courant oscillant en $\sin\varphi$ traverse la jonction Josephson.

On notera, sans rentrer dans les détails, que le paramètre caractéristique $I_c$ est une fonction de la composante du champ magnétique dans un plan transverse à la direction d'empilement des couches de la jonction Josephson.

Pour une utilisation dans un circuit de logique rapide RSFQ, ou par exemple encore en tant qu'oscillateur ou mélangeur dans un circuit quelconque, il est nécessaire de pouvoir commander le mode de fonctionnement de la jonction Josephson pour la basculer soit en mode actif (en fonctionnement : « ON »), dans lequel le courant circulant dans la jonction oscille ; soit en mode inactif (hors fonctionnement : « OFF »), dans lequel le courant circulant dans la jonction est continu.

Jusqu'à présent, un moyen disponible pour commander une jonction Josephson est de modifier la polarisation (en tension *V* ou en courant *I*) qui lui est appliquée pour passer du mode inactif au mode actif, et inversement.

Dans un circuit de logique rapide, pour générer la tension de commande d'une jonction Josephson principale, il est courant d'utiliser une matrice de jonctions Josephson, qui nécessitent à leur tour d'être en permanence en mode actif. Ainsi, le bilan énergétique d'un tel circuit de logique rapide est très défavorable. Comme dans tout système électronique, se pose également le problème de la dissipation de l'énergie fournie au système.

Cette contrainte dans la manière de commander une jonction Josephson limite les utilisations envisageables des composants électroniques correspondants.

Par ailleurs, un autre moyen pour commander une jonction Josephson est décrit dans le document US 2011/267878 A1. Celui-ci divulgue une mémoire à accès aléatoire comportant une matrice de cellules, chaque cellule étant un dispositif à jonction de Josephson magnétique à hystérésis. Plus précisément, un dispositif est constitué d'un composant SQUID (selon l'acronyme anglais « Superconducting QUantum Interference Device ») dont les deux jonctions Josephson intègrent respectivement un élément ferromagnétique constitué d'une première couche ferromagnétique élémentaire de magnétisation fixe et une seconde couche ferromagnétique élémentaire de magnétisation variable, séparées l'une de l'autre par une couche additionnelle, telle qu'une couche d'oxyde. La magnétisation variable de la seconde couche est modifiée par un courant d'écriture adapté.

L'invention a pour but de pallier ce problème.

Pour cela l'invention a pour objet un circuit selon les revendications.

L'invention et ses avantages seront mieux compris à la lecture de la description qui va suivre, donnée uniquement à titre d'exemple illustratif et non limitatif, et faite en se référant aux dessins annexés sur lesquels :

- la figure 1 est un graphe courant-tension générique d'un composant électronique du type à jonction Josephson ;
- la figure 2 est une représentation schématique d'un premier mode de réalisation d'un composant électronique à jonction Josephson destiné à être intégré dans un circuit selon l'invention ;
- la figure 3 est une représentation schématique d'un second mode de réalisation d'un composant électronique à jonction Josephson destiné à être intégré dans un circuit selon l'invention ; et,
- la figure 4 est une représentation schématique d'un troisième mode de réalisation d'un composant électronique à jonction Josephson destiné à être intégré dans un circuit selon l'invention ; et,
- la figure 5 est une représentation schématique d'un quatrième mode de réalisation d'un composant électronique à jonction Josephson destiné à être intégré dans un circuit selon l'invention

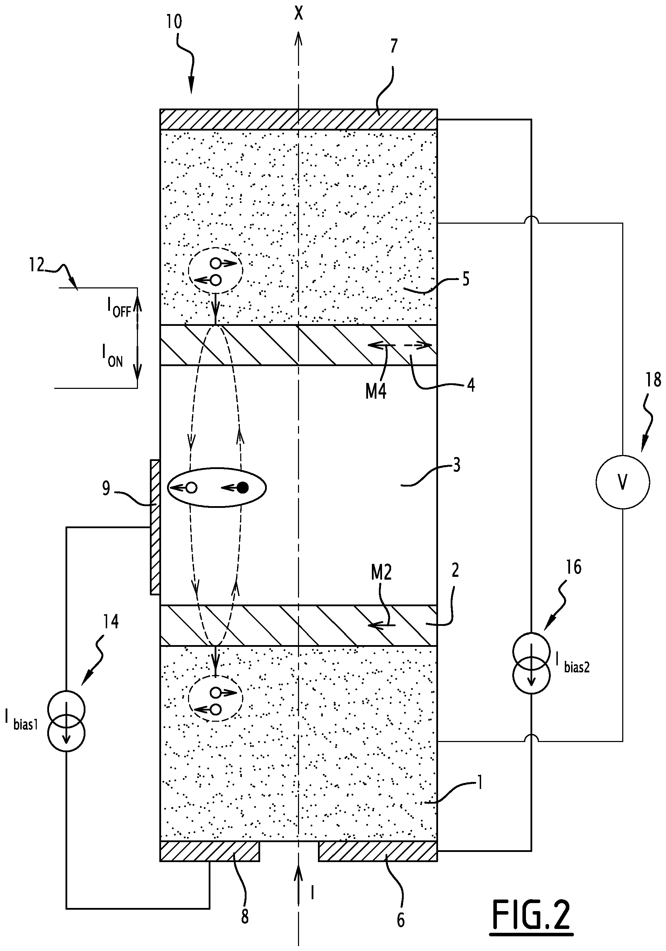

En se référant à la figure 2, un premier mode de réalisation d'un composant à jonction Josephson va être présenté.

Selon ce premier mode de réalisation, le composant 10 résulte de l'empilement, selon une direction d'empilement X, d'une première couche 1, d'un premier polariseur 2, d'une couche intermédiaire 3, d'un second polariseur 4, et d'une seconde couche 5.

Les première et seconde couches, 1 et 5, sont réalisées en un matériau supraconducteur. Il s'agit de préférence d'un matériau supraconducteur à haute température critique, c'est-à-dire exhibant des propriétés de supraconduction pour des températures dans la gamme de 25 à 120° au-dessus du zéro absolu (-273 °C). Il s'agit par exemple d'un oxyde mixte de baryum de cuivre et d'yttrium, dénommé YBCO. L'oxyde $YBa_2Cu_3O_7$ est de préférence utilisé.

Une épaisseur des première et seconde couches, 1 et 5, peut être choisie a priori arbitrairement. Cependant, l'épaisseur minimale dépend du matériau utilisé. Pour l'YBCO, l'épaisseur des première et seconde couches est choisie entre 5 et 50 nm, de préférence entre 20 et 40 nm, de préférence encore égale à 30 nm.

La couche intermédiaire 3 est en un matériau conducteur du courant électrique. Le matériau de la couche intermédiaire est choisi par exemple parmi les oxydes complexes, tel que l'oxyde de $LaNiO_3$, les métaux normaux élémentaires, tels que le cuivre Cu, l'argent Ag, l'or Au, etc., ou encore les semiconducteurs.

Une épaisseur de la couche intermédiaire 3 devra être inférieure à une longueur $L_N$ dite longueur de cohérence dans le matériau conducteur, qui dépend du matériau effectivement utilisé pour la couche intermédiaire. Par exemple, pour $LaNiO_3$, l'épaisseur est choisie entre 0,1 et 100 nm, de préférence la plus courte possible, par exemple égale à 20 nm.

Les premier et second polariseurs, 2 et 4, sont en un matériau conducteur ferromagnétique. Ce matériau ferromagnétique est de préférence un oxyde de manganite de lanthane strontium, dénommé LCMO selon l'acronyme anglais correspondant. Un milieu ferromagnétique répondant à la formule $La_{0.7}Ca_{0.3}MnO_3$ est de préférence utilisé.

Le premier polariseur 2 présente une première magnétisation M2 selon une première direction de magnétisation. Dans un exemple de réalisation simple, la première magnétisation M2 est constante en sens et en intensité au cours de l'utilisation du composant et est perpendiculaire à la direction d'empilement.

Le second polariseur 4 présente une seconde magnétisation M4. La seconde magnétisation M4 est constante en intensité, mais sa direction et son sens par rapport à la première direction de magnétisation varie au cours de l'utilisation du composant. Dans le mode de réalisation simple, seulement le sens de la magnétisation M4 varie selon la première direction de magnétisation, qui est constante.

Une épaisseur des premier et second polariseurs, 2 et 4, est choisie inférieure à une longueur de cohérence $L_P$ dans le matériau ferromagnétique. Dans le cas du LCMO, l'épaisseur est de préférence entre 0,1 et 100 nm, de préférence égale à 5 nm.

Le principe physique mis en oeuvre dans le présent composant est l'effet Andreev. Cet effet est connu et présenté par exemple dans l'article T.M. Klapwijk, « proximity effect from an Andreev perspective », Journal of superconductivity: Incorporating Novel Magnetism, Vol. 17, No. 5, October 2004.

Cet effet à lieu à l'interface entre un milieu conducteur et un milieu supraconducteur.

Selon cet effet, un électron se déplaçant dans le milieu conducteur et incident sur l'interface avec le milieu supraconducteur peut conduire à la transmission d'une paire de Cooper dans le supraconducteur et à la réflexion d'un trou dans le milieu conducteur.

La conservation de l'impulsion impose que, si l'électron possède une impulsion p (vectorielle), la paire de Cooper possédera une impulsion 2.p et le trou, une impulsion -p.

Si l'électron possède un spin s, le trou possède soit un spin -s (la paire électron-trou constituant alors un singulet dont le spin total est nul), soit un spin s (la paire électron-trou constituant un triplet dont le spin total est égal à l'unité).

Dans le premier cas, un supercourant dit conventionnel est généré à travers l'interface. Le supercourant conventionnel transporte une charge mais pas de spin.

Dans le second cas, un supercourant dit non conventionnel est généré à travers l'interface. Cela nécessite un processus dit de « renversement du spin » (« spin-flip » en anglais) à l'interface entre le milieu supraconducteur et le milieu conducteur, qui est présent notamment quand le milieu conducteur est un milieu ferromagnétique (par exemple du LCMO). Le supercourant non conventionnel transporte ainsi une charge et un spin.

Il résulte de cet effet que la fonction d'onde des paires électron/trou dans le milieu conducteur est couplée, au niveau de l'interface, avec la fonction d'onde des paires de Cooper du milieu supraconducteur.

Puisque le supercourant non conventionnel est polarisé en spin, il est sensible aux effets de polarisation à l'interface entre le milieu conducteur et le milieu supraconducteur. La présence d'un polariseur (présentant une magnétisation déterminée) à l'interface entre le milieu conducteur et le milieu supraconducteur permet de sélectionner, parmi les électrons ou les trous incidents, les électrons ou les trous dont le spin est parallèle à la magnétisation du polariseur et, par conséquent, ceux qui peuvent effectivement participer à la circulation d'un supercourant non conventionnel à travers l'interface.

Dans le composant présenté ci-dessus, un polariseur 2, respectivement 4, est prévu à l'interface entre la couche intermédiaire 3 et la couche supraconductrice 1, respectivement 5, de manière à contrôler les supercourants non conventionnels à chaque interface.

De plus, les paires électron/trou générées à une interface peuvent circuler dans la couche intermédiaire 3. Par exemple, une paire électron/trou générée à l'interface entre la couche intermédiaire 3 et la seconde couche supraconductrice 5 portant un supercourant non conventionnel, peut circuler à travers la couche intermédiaire 3 jusqu'à l'interface entre la couche intermédiaire 3 et la première couche supraconductrice 5 pour participer à un supercourant non conventionnel au niveau de cette interface.

De ce fait, il existe des états liés entre les paires électron/trou dans la couche intermédiaire et les paires de Cooper dans la première couche supraconductrice 1 et dans la seconde couche supraconductrice 5. Il y a donc interaction entre les fonctions d'ondes des porteurs de charge des première et deuxième couches supraconductrices, via un mécanisme de génération et transmission de paires électron/trou à travers la couche intermédiaire.

Pour introduire effectivement un couplage entre les fonctions d'onde des première et seconde couches supraconductrices entre elles, les épaisseurs des couches ferromagnétiques 2 et 4 et de la couche intermédiaire 3 sont choisies en fonction de la longueur de cohérence $L_P$ des paires électron/trou dans le matériau ferromagnétique et de la longueur de cohérence $L_N$ des paires électron/trou dans le matériau intermédiaire. Par exemple, la longueur de cohérence la plus petite entre ces deux longueurs est choisie comme contrainte.

De manière générale, pour un matériau la longueur de cohérence s'écrit :

$$l_i = \frac{\hbar v_{Fi}}{2\pi KT}$$

dans le régime balistique, ou

$$l_i = \sqrt{\frac{\hbar D_i}{2\pi KT}}$$

dans le régime diffusif. Où

- *T* est la température absolue ;
- *K* est la constante de Boltzmann ;
- $\hbar$ est la constante de Planck réduite ;
- $v_{Fi}$ est la vitesse de Fermi dans le matériau *i* ; et,
- $D_i$ est la constante de diffusion électronique dans le matériau *i*.

Les mesures de la longueur de cohérence $L_P$ montrent qu'elle est supérieure à 30 nm dans le LCMO.

Compte tenu de la vitesse de Fermi $v_{FN}$ qui vaut environ $10^5$ m/s dans le LaNiO$_3$, la longueur de cohérence $L_N$ est plus longue dans ce matériau que la longueur $L_P$ (et ceci d'autant plus que le matériau conducteur est porté à basse température), et encore plus longue dans des métaux tels que Au ou Ag.

En plaçant un polariseur à chacune des interfaces entre la couche intermédiaire et les couches supraconductrices, un ensemble polariseur/analyseur est créé permettant de contrôler la polarisation relative des supercourants non conventionnels à travers chaque interface: Si les première et seconde magnétisations sont antiparallèles (180° entre elles), aucun des porteurs de charge, électron ou trou, généré à la première interface avec un spin parallèle à la première magnétisation, ne pourra, après circulation à travers la couche intermédiaire, traverser le second polariseur et atteindre la seconde interface. Aucun courant supraconducteur ne pourra traverser la jonction Josephson. Celle-ci sera dans un état bloqué.

En revanche, lorsque les première et seconde magnétisations sont parallèles entre elles (0°), un porteur de charge, électron ou trou, généré, à la première interface, avec un spin parallèle à la première magnétisation, pourra, après circulation à travers la couche intermédiaire, traverser le second polariseur et atteindre la seconde interface où il pourra participer à la génération d'un courant. Un courant supraconducteur pourra donc circuler à travers la jonction Josephson. Celle-ci sera dans un état passant.

Le composant 10 comporte ainsi un moyen de commande 12 propre à modifier l'orientation de la seconde magnétisation M4 le long de la direction de magnétisation pour placer le composant soit dans l'état passant, dans lequel les première et seconde magnétisations sont parallèles entre elles, soit dans un état bloquant, dans lequel les première et seconde magnétisations sont antiparallèles entre elles.

Le moyen de commande 12 est par exemple constitué d'un circuit permettant d'appliquer une impulsion de courant le long d'un fil positionné convenablement au voisinage du second polariseur 4. Une impulsion de courant $I_{ON}$ dans un premier sens permet de placer la seconde magnétisation parallèlement à la direction de magnétisation ; une impulsion de courant $I_{OFF}$ dans un second sens, opposé au premier, permet de placer la seconde magnétisation antiparallèlement à la direction de magnétisation.

Le composant 10 peut comporter une première source 14 de polarisation électrique propre à appliquer un premier courant de biais ou une première tension de biais entre une borne 8 en contact de la première couche 1 et une borne 9 en contact de la couche intermédiaire 3. Dans le mode de réalisation actuellement envisagé, la première source 14 est une source d'un premier courant de biais $I_{bias1}$.

Le composant 10 peut comporter une seconde source de courant 16 propre à appliquer un second courant de biais $I_{bias2}$ entre une borne 6 en contact de la première couche 1 et une borne 7 en contact avec la seconde couche 5.

Le composant 10 peut comporter un dispositif 18 de mesure de la tension propre à détecter une tension entre des première et seconde couches 1 et 5.

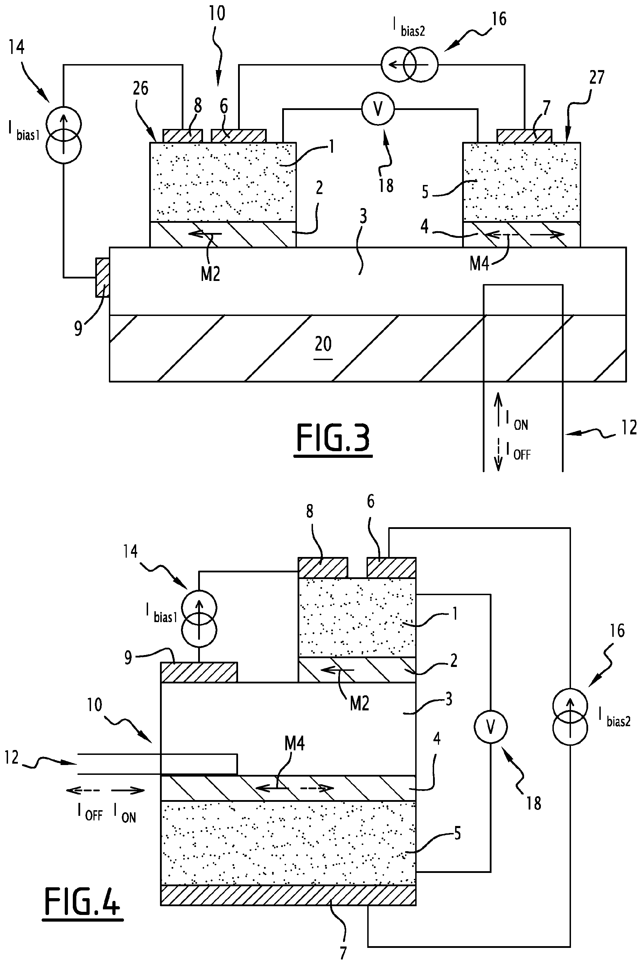

Un second mode de réalisation va être décrit en référence à la figure 3. Les éléments du second mode de réalisation similaires ou identiques à ceux du premier mode de réalisation sont indiqués par le même chiffre de référence.

Le composant 10 comporte un substrat 20. Le matériau du substrat est par exemple du saphir, du SrTiO$_3$, etc.

Une couche intermédiaire 3 recouvre le substrat 20.

Une face supérieure libre de la couche intermédiaire 3, opposée à une face inférieure en contact avec le substrat 20, porte des première et seconde électrodes 26 et 27, respectivement.

La première électrode 26 résulte de la superposition d'un premier polariseur 2 en un matériau ferromagnétique et d'une première couche 1 en un matériau supraconducteur.

La seconde électrode 27 résulte de la superposition d'un second polariseur 4 en un matériau ferromagnétique et d'une seconde couche 5 en un matériau supraconducteur.

Les première et seconde couches 1 et 5, les premier et second polariseurs 2 et 4 et la couche intermédiaire 3 sont similaires aux couches correspondantes du premier mode de réalisation de la figure 2, en termes de matériau et d'épaisseur.

Les premier et second polariseurs 2 et 4 sont avantageusement réalisés simultanément au cours d'une étape de croissance d'un matériau ferromagnétique. Elles présentent alors la même épaisseur.

Les première et seconde couches 1 et 5 sont avantageusement réalisées simultanément au cours d'une étape de croissance d'un matériau supraconducteur. Elles présentent alors la même épaisseur.

Compte tenu des dimensions évoquées ci-dessus, une technologie de réalisation d'un tel composant est la lithographie par faisceau d'électrons.

Le moyen de commande 12 comporte un fil disposé à proximité du second polariseur 4 de manière à ce qu'un courant $I_{ON}$ ou $I_{OFF}$ circulant dans le fil produise un champ magnétique propre à modifier l'orientation de la magnétisation M4 du polariseur 4.

Une première source 14 de polarisation électrique propre à générer un premier courant de biais peut être connectée entre la couche intermédiaire 3 et la première couche 1 supraconductrice.

Une seconde source 16 de polarisation électrique propre à appliquer un second courant de biais peut être connectée à des bornes 6 et 7 prévues sur chacune des électrodes 26 et 27.

Sur la figure 4 encore un autre mode de réalisation du composant 10 est représenté. Ce mode de réalisation est similaire à celui de la figure 2, à l'exception du fait que les couches 1 et 2 ont une extension transversale réduite par rapport à la couche 3. De cette manière, la couche 2 ne recouvre pas la totalité d'une surface de contact de la couche 3, qui peut alors recevoir la borne 9 d'injection du premier courant de $I_{bias1}$, lorsque celui-ci existe.

Il est à noter que le sens des premier et second courants de biais indiqué sur les figures est arbitraire et peut être réglé comme il convient, en fonction de l'application que trouve le composant.

En variante, c'est la magnétisation M2 de la couche 2 qui est commandée au cours de l'utilisation du composant 10 et non la magnétisation M4.

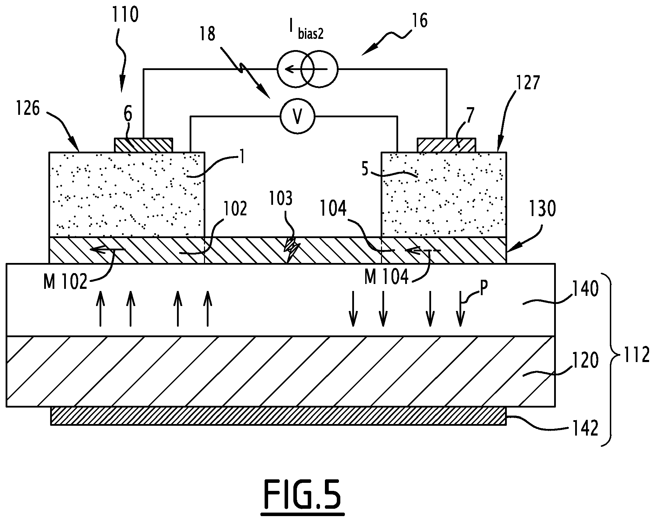

A la figure 5 est représenté un autre mode de réalisation du composant. Dans ce mode de réalisation, le composant 110 ne comporte pas de couche intermédiaire en un matériau normal et comporte une unique couche 130 en matériau ferromagnétique.

Les premier et second polariseurs 102 et 104 sont alors constitués par des zones de la couche ferromagnétique 130, à l'aplomb des première et seconde couches supraconductrices 1 et 5, respectivement.

La séparation intermédiaire entre les premier et second polariseurs 102 et 104 est alors constituée par une paroi 103 entre domaines de magnétisation. La paroi 103 constitue la frontière entre un domaine de la couche ferromagnétique 130 ayant une magnétisation dans une première direction et un domaine de la couche ferromagnétique 130 ayant une magnétisation dans une seconde direction différente de la première.

La paroi 103 est déplaçable vers la première électrode 126, de manière à étendre le domaine correspondant au second polariseur 104, ou vers la seconde électrode 127, de manière à étendre le domaine correspondant au premier polariseur 102, grâce à un moyen de commande 112 constitué d'une couche ferroélectrique, une grille et une électrode.

La couche ferroélectrique 140 est disposée entre le substrat 120 et la couche ferromagnétique 130. Elle est par exemple composée d'un oxyde de ferrite de bismuth, ou BFO (pour « Bismuth Ferric Oxide » en anglais).

Le substrat 120 est ici composé de STO dopé au Niobium (Nb:STO), de sorte que le substrat 120 est en un matériau conducteur du courant de manière à constituer une grille.

La couche ferroélectrique 140 possède une polarisation diélectrique rémanente locale P. La polarisation P est un vecteur, comme représenté schématiquement sur la figure 5. L'orientation de la polarisation P est régulée par une impulsion de tension entre l'électrode métallique 142 placée sous le substrat 120 et les électrodes 6 et/ou 7 (de façon à réguler l'orientation de la polarisation P à l'aplomb des électrodes 126 et/ou 127 respectivement).

L'orientation de la polarisation P en une zone de la couche ferroélectrique 140 modifie l'ancrage de la magnétisation de la zone voisine de la couche ferromagnétique 130.

Ainsi, en régulant la distribution de polarisation P dans la couche ferromagnétique 140 en présence d'un champ magnétique externe, les domaines de magnétisation de la couche ferromagnétique 130 peuvent être étendus ou réduits, c'est-à-dire que la paroi 103 peut être déplacée.

En fonction de la position de la paroi 103, les deux polariseurs 102 et 104 peuvent appartenir au même domaine et avoir la même magnétisation, le composant 110 étant alors passant, ou appartenir à des domaines différents et avoir des magnétisations différentes, de préférence antiparallèles, le composant étant alors bloquant.

On a donc là, un mécanisme de contrôle de la jonction de Josephson.

Il est à noter que dans ce mode de réalisation, en s'affranchissant d'une interface intermédiaire en un matériau normale, la distance entre les première et seconde couches 1 et 5 est choisie en fonction de la longueur de cohérence $L_P$ dans le matériau ferromagnétique des polariseurs 102 et 104 uniquement.

Le composant 10 (ou 110) a trois modes de fonctionnement :

Dans un premier mode de fonctionnement, adapté à un composant 10 ne comportant qu'une première source 14 de polarisation électrique, l'une des interfaces supraconducteur/ferromagnétique joue un rôle passif, c'est-à-dire que le courant ne circule pas à travers la couche ferromagnétique correspondante. Sur le montage de la figure 3, des électrons sont injectés dans la couche intermédiaire 3 au moyen d'un courant de biais $I_{bias1}$. Pour cela, une source 14 est connectée entre la couche intermédiaire 3 et, par exemple, la première couche 1 supraconductrice, aux moyens de bornes adaptées 9 et 8. Par conséquent, c'est l'interface entre les couches 4 et 5 qui est ici passive. L'avantage de ce premier mode de fonctionnement réside en ce que le courant circule uniquement dans une moitié du composant, limitant ainsi la dissipation d'énergie.

Dans ce premier mode de fonctionnement, si le courant $I_{bias1}$ est au-delà du courant critique $I_c$, lorsque l'on bascule le composant dans l'état passant ($I_{ON}$), un courant oscillant supraconducteur circule au travers de l'interface entre les couches 2 et 3. En revanche, lorsque le composant est dans l'état bloqué ($I_{OFF}$), aucun courant alternatif ne circule à travers le composant 10.

Dans un second mode de fonctionnement, adapté à un composant 10 ne comportant qu'une seconde source de courant de biais 16, une source de courant de biais 16 est prévue, propre à appliquer un courant $I_{bias2}$, entre des bornes 6 et 7 du composant 10, de manière à permettre, lorsqu'il est dans l'état passant, la circulation d'un courant supraconducteur oscillant (état actif de la jonction Josephson).

Dans ce second mode de fonctionnement, si le courant $I_{bias2}$ est tel que l'on se situe dans la partie de la caractéristique courant-tension de la jonction Josephson au-delà du courant critique $I_c$ (cf. figure 1), lorsque l'on bascule le composant dans l'état passant ($I_{ON}$), un courant oscillant circule à travers le composant. En revanche, lorsque le composant est dans l'état bloqué ($I_{OFF}$), aucun courant alternatif ne circule à travers le composant, bien que la tension appliquée soit non nulle et qu'un courant continu circule à travers le composant.

Dans un troisième mode de fonctionnement, les courants $I_{bias1}$ et $I_{bias2}$ sont appliqués simultanément.

Dans ce troisième mode de fonctionnement, si la somme des courants $I_{bias1}$ et $I_{bias2}$ est telle que l'on se situe dans la partie de la caractéristique courant-tension de la jonction Josephson au-delà du courant critique $I_c$, lorsque l'on bascule le composant dans l'état passant ($I_{ON}$), un courant oscillant circule à travers le composant. En revanche, lorsque le composant est dans l'état bloqué ($I_{OFF}$), aucun courant alternatif ne circule à travers le composant, bien que la tension appliquée soit non nulle. Une faible puissance électrique est nécessaire à la commande du composant. L'avantage de ce troisième mode de fonctionnement est de séparer les mises en oeuvre des fonctions d'alimentation et de seuil (condition décrite ci-après).

Ainsi, un composant électronique à jonction Josephson pouvant être commandé autrement que par une variation de la tension appliquée entre ses bornes est obtenu. La commande du changement d'état du composant est une impulsion de champ magnétique, qui peut être causée par la circulation d'une impulsion de courant de commande (dans ou au voisinage de la couche ferromagnétique).

Puisque le composant est sensible aux variations du champ magnétique, une impulsion magnétique modifiant la magnétisation d'un des polariseurs de manière à basculer le composant de l'état bloquant vers l'état passant ou inversement, une utilisation de ce composant en tant que capteur de variations du champ magnétique est envisageable.

Bien que le principe du présent composant puisse être mis en oeuvre au moyen de matériau supraconducteur à basse température, l'utilisation de matériaux supraconducteurs à haute température est préférable en particulier pour permettre l'intégration du composant électronique dans des circuits RSFQ mis en oeuvre dans des systèmes micro-cryogéniques portables.

## Revendications

1. Circuit supraconducteur du type « Rapid Single Flux Quantum » - RSFQ, comportant un oscillateur local, **caractérisé en ce que** ledit oscillateur local est un composant à jonction Josephson (10, 110) du type comportant des première et seconde couches (1, 5) en un matériau supraconducteur, séparées l'une de l'autre par :

   - une interface intermédiaire (3, 103), constituée d'un matériau conducteur du courant électrique ; et,
   - des premier et second polariseurs (2, 4) en un matériau ferromagnétique, le premier polariseur, présentant une première magnétisation (M2), étant interposé entre l'interface intermédiaire (3, 103) et la première couche (1), et le second polariseur, présentant une seconde magnétisation (M4), étant interposé entre l'interface intermédiaire (3, 103) et la seconde couche (5),

   le composant comportant, en outre, un moyen de commande (12, 112) propre à modifier au moins une magnétisation parmi les première et seconde magnétisations pour placer le composant soit dans un état passant, dans lequel les première et seconde magnétisations sont parallèles entre elles, soit dans un état bloquant, dans lequel les première et seconde magnétisations sont antiparallèles entre elles.

2. Circuit supraconducteur selon la revendication 1, dans lequel une distance entre les première et seconde couches (1, 5) est choisie en fonction d'une longueur de cohérence ($L_N$) des porteurs de charge dans la couche intermédiaire (3) et/ou une longueur de cohérence ($L_P$) dans les polariseurs (2, 4 ; 102, 104), entre 0,1 nm et 200 nm, de préférence entre 5 nm et 100 nm, de préférence encore égale à 40 nm.

3. Circuit supraconducteur selon la revendication 1 ou la revendication 2, dans lequel le matériau supraconducteur des première et seconde couches (1, 5) est un matériau supraconducteur à haute température critique.

4. Circuit supraconducteur selon la revendication 3, dans lequel le matériau supraconducteur à haute température critique est du YBCO.

5. Circuit supraconducteur selon l'une quelconque des revendications 1 à 4, dans lequel une épaisseur des première et seconde couches (1, 5) est choisie entre 20 et 40 nm, de préférence 25 et 35 nm, de préférence encore égale à 30 nm.

6. Circuit supraconducteur selon l'une quelconque des revendications 1 à 5, dans lequel le matériau ferromagnétique des premier et second polariseurs (2, 4 ; 102, 104) est du LCMO.

7. Circuit supraconducteur selon l'une quelconque des revendications 1 à 6, dans lequel une épaisseur des premier et second polariseurs (2, 4) est choisie entre 3 et 10 nm, de préférence égale à 5 nm.

8. Circuit supraconducteur selon l'une quelconque des revendications 1 à 7, dans lequel l'interface intermédiaire étant constituée par une couche intermédiaire (3), le matériau de ladite couche intermédiaire (3) est un métal normal, choisi parmi les oxydes de métal normal ou les métaux normaux élémentaires.

9. Circuit supraconducteur selon l'une quelconque des revendications 1 à 8, dans lequel une épaisseur de la couche intermédiaire (3) est choisie entre 15 et 25 nm, de préférence égale à 20 nm.

10. Circuit supraconducteur selon l'une quelconque des revendications 8 à 9, dans lequel sont successivement empilées selon une direction d'empilement la première couche (1), le premier polariseur (2), la couche intermédiaire (3), le second polariseur (4) et la seconde couche (5).

11. Circuit supraconducteur selon l'une quelconque des revendications 8 à 9, comportant un substrat (20) en contact d'une face de la couche intermédiaire (3) opposée à la face de la couche intermédiaire (3) en contact avec les premier et second polariseur (2, 4), un matériau du substrat étant de préférence choisi parmi le saphir et le $SrTiO_3$.

12. Circuit supraconducteur selon l'une quelconque des revendications 1 à 7, dans lequel l'interface intermédiaire est constituée par une paroi de Bloch (103) entre domaines de magnétisation dans une couche ferromagnétique (130) s'étendant entre les première et seconde couche supraconductrices (1, 5).

13. Circuit supraconducteur selon l'une quelconque des revendications 1 à 12, comportant des première et seconde électrodes (26, 27 ; 126, 127), la première électrode résultant de l'empilement du premier polariseur (2, 102) et de la première couche (1) et la seconde électrode résultant de l'empilement du second polariseur (4, 104) et de la seconde couche (5).

14. Circuit supraconducteur selon l'une quelconque des revendications précédentes, **caractérisé en ce qu'**il comporte une source (14, 16) de polarisation électrique ($I_{bias1}$, $I_{bias2}$).

15. Circuit supraconducteur selon l'une quelconque des revendications précédentes, **caractérisé en ce qu'**il comporte un dispositif de mesure de la tension (18) propre à mesurer une différence de potentiel entre les première et seconde couches (1, 5) du composant.

**Patentansprüche**

1. Supraleitende Schaltung vom Typ "Rapid Single Flux Quantum" - RSFQ, umfassend einen lokalen Oszillator, **dadurch gekennzeichnet, dass** der lokale Oszillator eine Komponente mit Josephson-Kontakt (10, 110) des Typs ist, umfassend erste und zweite Schichten (1, 5) aus einem supraleitenden Material, getrennt voneinander durch:

   - eine Zwischenschnittstelle (3, 103), die aus einem elektrischen Strom leitenden Material besteht; und
   - erste und zweite Polarisatoren (2, 4) aus einem ferromagnetischen Material, wobei der erste Polarisator, der eine erste Magnetisierung (M2) aufweist, zwischen die Zwischenschnittstelle (3, 103) und die erste Schicht (1) eingeschoben ist, und wobei der zweite Polarisator, der eine zweite Magnetisierung (M4) aufweist, zwischen die Zwischenschnittstelle (3, 103) und die zweite Schicht (5) eingeschoben ist,

wobei die Komponente außerdem ein Steuermittel (12, 112) umfasst, die dazu geeignet ist, mindestens eine Magnetisierung aus der ersten und der zweiten Magnetisierung zu modifizieren, um die Komponente entweder in einen vorübergehenden Zustand zu bringen, in dem die erste und die zweite Magnetisierung parallel zueinander sind, oder in einen blockierenden Zustand, in dem die erste und die zweite Magnetisierung antiparallel zueinander sind.

2.  Supraleitende Schaltung nach Anspruch 1, wobei ein Abstand zwischen der ersten und der zweiten Schicht (1, 5) je nach einer Kohärenzlänge ($L_N$) der Ladungsträger in der Zwischenschicht (3) und/oder einer Kohärenzlänge ($L_P$) in den Polarisatoren (2, 4; 102, 104) zwischen 0,1 nm und 200 nm, vorzugsweise zwischen 5 nm und 100 nm, besonders bevorzugt gleich 40 nm ausgewählt ist.

3.  Supraleitende Schaltung nach Anspruch 1 oder Anspruch 2, wobei das supraleitende Material der ersten und zweiten Schicht (1, 5) ein supraleitendes Material mit einer hohen kritischen Temperatur ist.

4.  Supraleitende Schaltung nach Anspruch 3, wobei das supraleitende Material mit einer hohen kritischen Temperatur YBCO ist.

5.  Supraleitende Schaltung nach einem beliebigen der Ansprüche 1 bis 4, wobei eine Dicke der ersten und der zweiten Schicht (1, 5) ausgewählt ist aus 20 und 40 nm, vorzugsweise 25 und 35 nm, noch bevorzugter gleich 30 nm.

6.  Supraleitende Schaltung nach einem beliebigen der Ansprüche 1 bis 5, wobei das ferromagnetische Material des ersten und des zweiten Polarisators (2, 4. 102, 104) LCMO ist.

7.  Supraleitende Schaltung nach einem beliebigen der Ansprüche 1 bis 6, wobei eine Dicke des ersten und des zweiten Polarisators (2, 4) ausgewählt ist zwischen 3 und 10 nm, vorzugsweise gleich 5 nm.

8.  Supraleitende Schaltung nach einem beliebigen der Ansprüche 1 bis 7, wobei, da die Zwischenschnittstelle aus einer Zwischenschicht (3) besteht, das Material der Zwischenschicht (3) ein normales Metall ist, ausgewählt aus den normalen Metalloxiden oder den normalen elementaren Metallen.

9.  Supraleitende Schaltung nach einem beliebigen der Ansprüche 1 bis 8, wobei eine Dicke der Zwischenschicht (3) ausgewählt ist zwischen 15 und 25 nm, vorzugsweise gleich 20 nm.

10. Supraleitende Schaltung nach einem beliebigen der Ansprüche 8 bis 9, wobei aufeinanderfolgend gemäß einer Stapelungsrichtung die erste Schicht (1), der erste Polarisator (2), die Zwischenschicht (3), der zweite Polarisator (4) und die zweite Schicht (5) gestapelt sind.

11. Supraleitende Schaltung nach einem beliebigen der Ansprüche 8 bis 9, umfassend ein Substrat (20) in Kontakt mit einer Fläche der Zwischenschicht (3), die der Fläche der Zwischenschicht (3) in Kontakt mit dem ersten und dem zweiten Polarisator (2, 4) gegenüber liegt, wobei ein Material des Substrats vorzugsweise ausgewählt ist aus Saphir und $SrTiO_3$.

12. Supraleitende Schaltung nach einem beliebigen der Ansprüche 1 bis 7, wobei die Zwischenschnittstelle aus einer Bloch-Wand (103) zwischen Magnetisierungsbereichen in einer ferromagnetischen Schicht (130) besteht, die sich zwischen der ersten und der zweiten supraleitenden Schicht (1, 5) erstreckt.

13. Supraleitende Schaltung nach einem beliebigen der Ansprüche 1 bis 12, umfassend erste und zweite Elektroden (26, 27; 126, 127), wobei sich die erste Elektrode aus der Stapelung des ersten Polarisators (2, 120) und der ersten Schicht (1) ergibt, und sich die zweite Elektrode aus der Stapelung des zweiten Polarisators (4, 104) und der zweiten Schicht (5) ergibt.

14. Supraleitende Schaltung nach einem beliebigen der vorhergehenden Ansprüche, **dadurch gekennzeichnet, dass** sie eine Quelle (14, 16) der elektrischen Polarisation ($I_{bias1}$, $I_{bias2}$) umfasst.

15. Supraleitende Schaltung nach einem beliebigen der vorhergehenden Ansprüche, **dadurch gekennzeichnet, dass** sie eine Vorrichtung zur Messung der Spannung (18) umfasst, die geeignet ist, um eine Potenzialdifferenz zwischen der ersten und der zweiten Schicht (1, 5) der Komponente zu messen.

**Claims**

1. A supraconductor circuit of a « Rapid Single Flux Quantum » - RSFQ type, comprising a local oscillator, **characterised in that** said local oscillator is a Josephson junction component (10, 110) of the type comprising first and second layers (1, 5) made from a superconducting material, separated one from the other by :

   - an intermediate interface (3, 103), made from an electrically conductive material; and,
   - first and second polarizers (2, 4), made from a ferromagnetic material, the first polarizer, having a first magnetisation (M2), being interposed between the intermediate interface (3, 103) and the first layer (1), and the second polarizer, having a second magnetisation (M4), being interposed between the intermediate interface (3, 103) and the second layer (5),

   the component further comprising a control means (12, 112) able to modify at least one magnetisation among the first and second magnetisations to place the component either in an on state, wherein the first and second magnetisations are parallel one with the other, or in an off state, wherein the first and second magnetisations are antiparallel one with the other.

2. Supraconductor circuit according to claim 1, wherein a distance between the first and second layers (1, 5) is chosen, according to a coherence length ($L_N$) of the charge carriers in the intermediate interface (3) and/or a coherence length ($L_P$) of the charge carriers in the polarizers (2, 4 ; 102, 104), between 0,1 nm and 200 nm, preferably between 5 nm and 100 nm, more preferably equal to 40 nm.

3. Supraconductor circuit according to claim 1 or claim 2, wherein the superconducting material of the first and second layers (1, 5) is a superconducting material with a high critical temperature.

4. Supraconductor circuit according to claim 3, wherein the superconducting material with a high critical temperature is YBCO.

5. Supraconductor circuit according to any one of the claims 1 to 4, wherein a thickness of the first and second layers (1, 5) is chosen between 20 and 40 nm, preferably 25 and 35 nm, more preferably equal to 30 nm.

6. Supraconductor circuit according to any one of the claims 1 to 6, wherein the ferromagnetic material of the first and second polarizers (2, 4 ; 102, 104) is LCMO.

7. Supraconductor circuit according to any one of claims 1 to 6, wherein a thickness of the first and second polarizers (2, 4) is chosen between 3 and 10 nm, preferably equal to 5 nm.

8. Supraconductor circuit according to any one of claims 1 to 7, wherein, the intermediate interface being made of an intermediate layer (3), the material of said intermediate layer (3) is a normal metal, chosen among normal metal oxides or elementary normal metals.

9. Supraconductor circuit according to any one of claims 1 to 8, wherein a thickness of the intermediate layer (3) is chosen between 15 and 25 nm, preferably equal to 20 nm.

10. Supraconductor circuit according to any one of the claims 8 to 9, wherein the first layer (1), the first polarizer (2), the intermediate layer (3), the second polarizer (4) and the second layer (5) are successively stacked along a stacking direction.

11. Supraconductor circuit according to any one of the claims 8 to 9, comprising a substrate (20) in contact with one surface of the intermediate layer (3) opposite the surface of the intermediate layer (3) in contact with the first and second polarizers (2, 4), the material of the substrate being preferably chosen among sapphire and $SrTiO_3$.

12. Supraconductor circuit according to any one of the claims 1 to 7, wherein the intermediate interface s made by a Bloch wall (103) between magnetisation domains in the ferromagnetic layer (130), that extends between the first and second superconducting layers (1, 5).

13. Supraconductor circuit according to any one of the claims 1 to 12, comprising first and second electrodes (26, 27 ; 126, 127), the first electrode resulting from the stacking of the first polarizer (2, 102) and the first layer (1) and the second electrode resulting from the stacking of the second polarizer (4, 104) and the second layer (5).

14. Supraconductor circuit according to any one of the preceding claims, **characterised in that** it comprises a source (14, 16) of electric bias ($I_{bias1}$, $I_{bias2}$).

15. Supraconductor circuit according to any one of the preceding claims, **characterised in that** it comprises a voltage measuring device (18) able to measure the voltage across the first and second layers (1, 5) of the component.

FIG.1

**FIG.2**

FIG.3

FIG.4

## FIG.5

## RÉFÉRENCES CITÉES DANS LA DESCRIPTION

**Documents brevets cités dans la description**

• US 2011267878 A1

**Littérature non-brevet citée dans la description**

• **T.M. KLAPWIJK.** proximity effect from an Andreev perspective. *Journal of superconductivity: Incorporating Novel Magnetism,* Octobre 2004, vol. 17 (5